# EUROPEAN PATENT APPLICATION

(11) **EP 4 276 538 A1**
(43) Date of publication of application: **15.11.2023**
(21) Application number: 22173165.6
(22) Date of filing: 13.05.2022
(51) Int. Cl.: G03F 7/20

(54) **METHODS AND SYSTEMS FOR GENERATING LINEWIDTH- OPTIMISED PATTERNS**

(71) Applicant: MYCRONIC AB, 183 03 Täby (SE)
(72) Inventor: Ihrén, Fredric, 187 45 Täby (SE)
(74) Representative: AWA Sweden AB

(57) **Abstract**

A method for obtaining a compensation pattern for a workpiece patterning device comprises printing (S2) of a calibration pattern with an exposure beam that is sweepable in a sweep direction. The calibration pattern has a multitude of exposed and unexposed lines extending in the sweep direction having different line widths and different distances to neighboring lines. Line widths are measured (S4). Deviations of the measured line widths are calculated (S6). Based on the calculated deviations, line width compensating data is computed (S8), intended for adapting line widths of pattern print data prior to printing to compensate for the calculated deviations. The line width compensating data is associated with at least an intended line width and whether the line is an exposed or unexposed line. A method for calibrating print data and a method for printing a pattern based thereon are also disclosed as well as systems therefore.

## Description

### TECHNICAL FIELD

The present technology relates to pattern printing and devices therefore and in particular to a method for obtaining a compensation pattern for a workpiece patterning device, a method for calibrating print data, a method for printing a pattern and devices therefore.

### BACKGROUND

In the semiconductor industry today, masks produced by laser-based mask writers are common for use for manufacturing of different kinds of advanced chips and image devices. Direct writers for e.g. electronic packaging are also standard today. During the last years, the production of larger and more accurate displays has also increased tremendously. Demands are therefore put e.g. on micro-lithographic printing processes to be faster, more accurate and less expensive.

In the field of micro-lithographic printing processes mask writers or direct writers may be based on a printing head providing one or several precision laser beams. The printing head and a substrate to which the writing is intended to be performed are movable relative to each other, either by moving the printing head or the substrate or both. By varying the power of the laser beam coordinated with the relative motion, an exposure pattern can be written onto the substrate.

Precision of the prints is of crucial importance. Deviations from the intended pattern, e.g. critical dimensions (CD), critical dimension linearity (CDL) or positioning errors, even in the range of a few to some hundred nanometers may be harmful or degrading for the final result. Such printing errors are typically caused by imperfections in the mechanical and/or optical properties of the printing head.

In the published US patent US 7,919,218 B2, a method for a multiple exposure beams lithography tool is disclosed. A method for patterning a workpiece covered with a layer sensitive to electromagnetic radiation by simultaneously using a plurality of exposure beams is described. It is determined if any of the beams have an actual position relative to a reference beam which differs from its intended position. An adjustment of the exposure dose for a wrongly positioned beam is performed if said beam is printed at an edge of a feature.

Such corrections are designed to correct for beam position errors, but deviations from the intended pattern can depend on many other reasons as well, which cannot be compensated by such an exposure adjustment.

In the published International patent application WO 2021/254726 A1, a method for obtaining a compensation pattern for a workpiece patterning device is disclosed. A calibration pattern is printed with a plurality of simultaneously operating exposure beams being sweepable in a second direction according to calibration pattern print data having a multitude of edges. Positions of the edges are measured. Deviations of the measured positions relative calibration pattern are calculated. Each deviation is associated with a used exposure beam, with a sweep position and a grid fraction position. Edge compensating data is computed for adapting edge representations of pattern print data prior to printing to compensate for the calculated deviations. The edge compensating data is dependent on the used exposure beam, the sweep position, and the grid fraction position.

Such corrections are designed to correct for CD errors, but CDL deviations may still be present.

### SUMMARY

A general object of the present technology is to improve critical dimension linearity.

The above object is achieved by methods and devices according to the independent claims. Preferred embodiments are defined in dependent claims.

In general words, in a first aspect, a method for obtaining a compensation pattern for a workpiece patterning device comprises printing of a calibration pattern with an exposure beam that is sweepable in a sweep direction. The printing is performed according to calibration pattern print data. The calibration pattern has a multitude of exposed and unexposed lines extending in the sweep direction having different line widths and different distances to neighboring lines. Line widths of the lines in a scan direction perpendicular to the sweep direction in the printed calibration pattern are measured. Deviations of the measured line widths of the lines relative intended line widths of the edges according to the calibration pattern print data are calculated. Based on the calculated deviations, line width compensating data is computed. The line width compensating data is intended for adapting line widths of pattern print data prior to printing to compensate for the calculated deviations. The line width compensating data is associated with at least an intended line width and whether the line is an exposed or unexposed line.

In a second aspect, a method for calibrating print data comprises obtaining of print data of the pattern to be printed. Lines in a sweep direction in the pattern to be printed are identified. Line properties of the lines are determined. The line properties comprises at least a line width and whether the lines are unexposed or exposed lines. A line width adjustment value is deduced for each identified line from line width compensating data. The line width compensating data is obtained by a method according to the first aspect based on the determined line width and on whether the line is an unexposed or exposed line. The print data defining the identified lines is adapted according to the line width adjustment value into line width compensated print data.

In a third aspect, a method for printing a pattern comprises obtaining of line width compensated print data. The line width compensated print data is obtained by a method according to the second aspect, related to the pattern to be printed. A printing process of a workpiece covered at least partly with a layer sensitive to electromagnetic or electron radiation is controlled based on the line width corrected print data.

In a fourth aspect, a system for obtaining a compensation pattern for a workpiece patterning device comprises a printing device, a measuring device, and a processing device. The printing device is configured for creating a calibration pattern with an exposure beam that is sweepable in a sweep direction. The printing device is configured to perform the printing according to calibration pattern print data. The calibration pattern has a multitude of exposed and unexposed lines extending in the sweep direction having different line widths and different distances to neighboring lines. The measuring device is arranged for measuring line widths of the lines in a scan direction perpendicular to the sweep direction in the printed calibration pattern. The processing device is configured for calculating deviations of the measured line widths of the lines relative intended line widths of the edges according to the calibration pattern print data. The processing device is further configured for computing, based on the calculated deviations, line width compensating data for adapting line widths of pattern print data prior to printing to compensate for the calculated deviations. The line width compensating data is associated with at least an intended line width and whether the line is a exposed or unexposed line.

In a fifth aspect, a device for processing print data defining a pattern to be printed comprises a processing circuitry and a memory. The memory comprises instructions executable by the processing circuitry. Thereby the processing circuitry is operative to obtain print data for the pattern to be printed. The processing circuitry is further operative to identify lines in a sweep direction in the pattern to be printed. The processing circuitry is further operative to determine line properties of the lines. The line properties comprise at least a line width and whether the lines are unexposed or exposed lines. The processing circuitry is further operative to deduce a line width adjustment value for each identified line from line width compensating data obtained by a method according to the first aspect based on the determined line width and on whether the line is an unexposed or exposed line. The processing circuitry is further operative to adapt the print data defining the identified lines according to the line width adjustment value into line width compensated print data.

In a sixth aspect, a printing device comprises a device for processing of line width compensated print data, a printing head and a control unit. The line width compensated print data obtained by a device for processing print data according to the fifth aspect. The printing device is the printing device of the system for obtaining a compensation pattern for a workpiece patterning device of the fourth aspect. The printing head has an exposure beam being sweepable in a sweep direction. The control unit is arranged to control an operation and relative motion of the printing head based on the line width compensated print data.

One advantage with the proposed technology is that compensation in data becomes very repeatable and can be calibrated by linearity measurements. Therefore, it can be adjusted to all conditions, and system types. Recalibrations can be performed by new measurements.

### BRIEF DESCRIPTION OF THE DRAWINGS

The invention, together with further objects and advantages thereof, may best be understood by making reference to the following description taken together with the accompanying drawings, in which:
FIG. 1 illustrates schematically a printing device;
FIG. 2 illustrates a printing utilizing a microsweeping exposure beam;
FIG. 3 is a diagram illustrating critical dimension linearity measurements;
FIG. 4 illustrates schematically a printing device having multiple exposure beams;
FIG. 5 illustrates a printing utilizing multiple exposure beams and microsweeping;
FIG. 6 is a flow diagram of steps of an embodiment of a method for obtaining a compensation pattern for a workpiece patterning device;
FIGS. 7A-B illustrate schematically exposed lines and unexposed lines, respectively;
FIG. 8 is a diagram illustrating the relation between intended line width and compensated line width;
FIG. 9 is a flow diagram of steps of an embodiment of a method for calibrating print data;
FIG. 10 illustrates adjustments of intensities in a bit map domain;
FIG. 11 is a diagram illustrating the relation between intended line width and line width compensation;
FIG. 12 is a flow diagram of steps of an embodiment of a method for printing a pattern;
FIGS. 13A-B illustrate schematically dense exposed lines and dense unexposed lines, respectively;
FIG. 14 is a schematic drawing of an embodiment of a system for obtaining a compensation pattern for a workpiece patterning device;
FIGS. 15A-B are schematic drawings of an embodiment of a device for processing print data defining a pattern to be printed; and
FIG. 16 is a schematic drawing of an embodiment of a printing device.

### DETAILED DESCRIPTION

Throughout the drawings, the same reference numbers are used for similar or corresponding elements.

For a better understanding of the proposed technology, it may be useful to begin with a brief overview of a printing system with microsweep functionality.

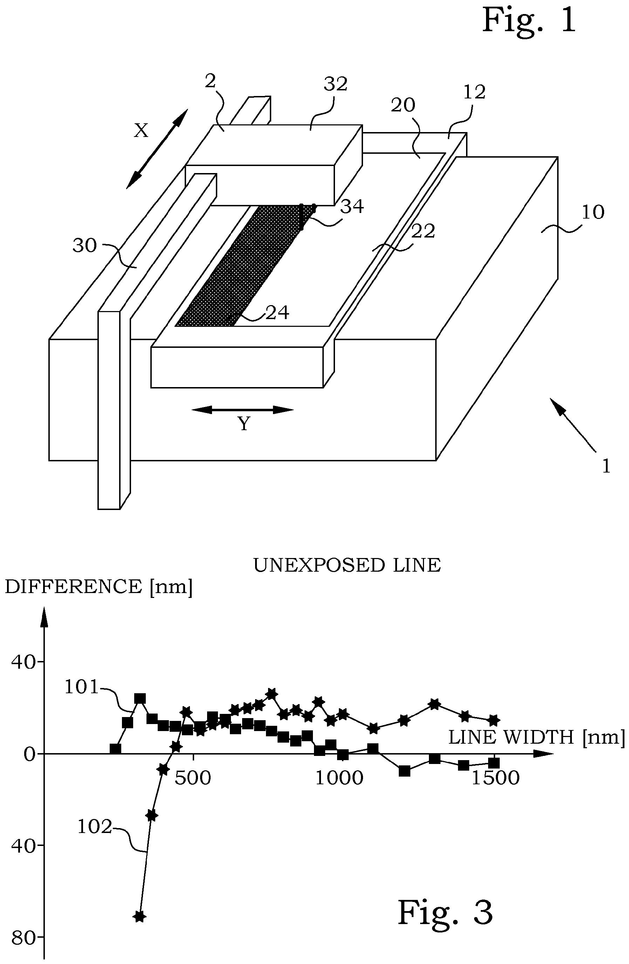

Figure 1 illustrates schematically a printing device 1 comprising a table 10, on which a workpiece support 12 is arranged. The workpiece support 12 is movable in a direction Y relative the table 10. On the workpiece support 12, a workpiece 20 is firmly attached. The surface of the workpiece 20 is provided with a layer sensitive to electromagnetic or particle radiation.

The printing device 1 further comprises a workpiece patterning device 2. The workpiece patterning device 2 comprises a stand 30 supporting a printing head 32. The printing head 32 is movable along the stand 30 in a direction X. The printing head 32 is arranged for providing an exposure beam 34 for exposure with electromagnetic or particle radiation, which exposure beam 34 is directed towards the workpiece 20.

The combined motion of the workpiece support 12 and the motion of the printing head 32 and, as will be described further below, by a microsweeping of the exposure beam 34, makes it possible to reach all areas on the workpiece 20 that are supposed to be exposed for radiation. In the figure, an exposed area 24 and an unexposed area 22 are illustrated.

As anyone skilled in the art realizes, the relative mechanical motions can in other embodiment also be achieved in other ways, e.g. that the printing head 32 is movable in two dimensions and/or that the workpiece support 12 is movable in two dimensions.

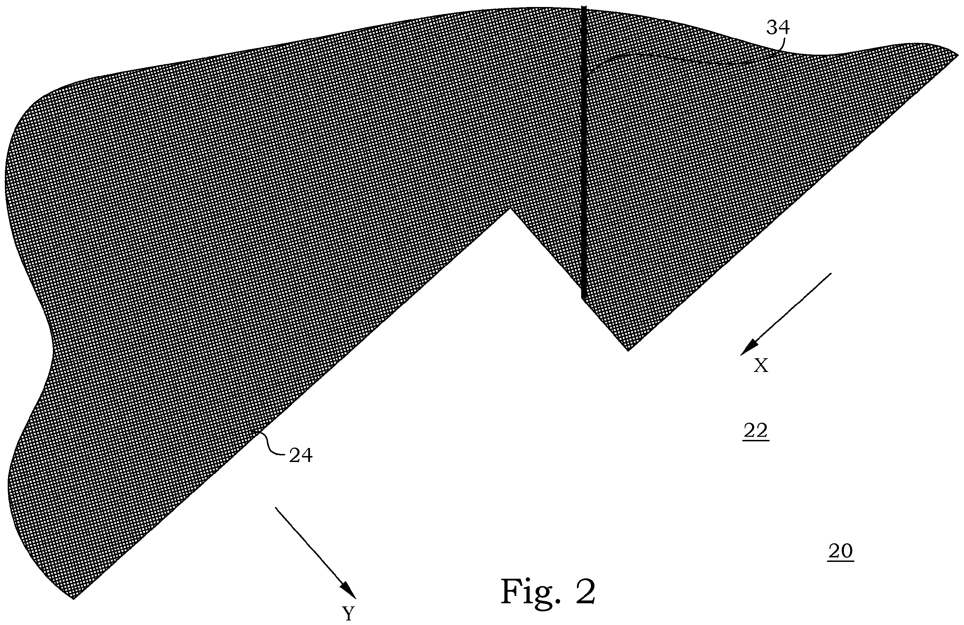

In the present type of printing device, microsweeping of the exposure beam is utilized. Figure 2 illustrates this in a schematic manner. By allowing the beams to be swept a small distance in a direction perpendicular to the main motion direction of the printing head, the width of the printed strip is increased, which also increases the overall printing speed. A portion of the workpiece 20 is shown. In the illustrated moment, an exposed area 24 is illustrated by hatching and an unexposed area 22 is illustrated without. Here, it will be understood that the actual degree of exposure also depends on the intensity of the exposure beam at each position. However, in this figure, the "exposed area" 24 is the area over which the exposure beam 34 has passed or should have passed if an intensity would have been applied at that instance.

From this, it is understood that the precision properties of the pattern in the X and Y directions, respectively, are partly governed by different apparatus properties. The precision in Y direction is highly dependent on e.g. the accuracy of the intensity variation control during a microsweep, or the uniformity of the microsweep speed. The precision in X direction is instead dependent on the accuracy of the printing head motion and the repeatability of the microsweep conditions.

One of the most important features of a pattern printing system is CD Linearity in X and Y. CD linearity is defined as measured linewidth deviation as a function of pattern linewidth. The characteristics of a typical mask printer or direct printer system of today is that X linearity drops before Y linearity. This sets the practical useful resolution of the writer system for production.

Figure 3 is a diagram illustrating the CD linearity in X and Y directions of a prior art pattern printer. The squares, connected to the curve 101, represent CD in the Y direction and the stars, connected to the curve 102, represent CD in the X direction. It can here be seen that the X curve 102 dives considerably when the line width becomes smaller than about 500 nm, while the Y-curve 101 is more or less unaffected. However, due to the changing behaviour in the X direction, the stable properties of the Y direction are not useful.

Furthermore, it has been found that the CD linearity profiles also depends on whether the line is a line of exposure or a "line of unexposure", i.e. a line where there is no exposure.

It has also been found that the curves may change depending on how dense the lines are provided. An isolated line may therefor have a different CD linearity profile compared to a line in the neighbourhood of other lines.

One contributing reason for these inlinearities is believed to be connected to the intensity distribution of the exposing beam. In order for a spot at the substrate to behave as being exposed, the light intensity has to exceed a certain threshold value. However, the edges of an exposing beam are not sharp, but instead the light spatial distribution is continuously varying over the beam. Spots at the substrate that are exposed for intensities lower than the threshold are expected to be etched away in a next production step. However, if a high degree of neighbouring spots is illuminated, the total "stray" intensity may reach over the threshold and the spot will behave as being exposed. Therefore, at very narrow structures, the exposure pattern of neighbour spots may give unpredicted changes of the areas in which an "exposure" is deemed to have occurred. This will give rise to a CD linearity profile that will vary with line width as well as with the line character, i.e. an exposed line or an unexposed line.

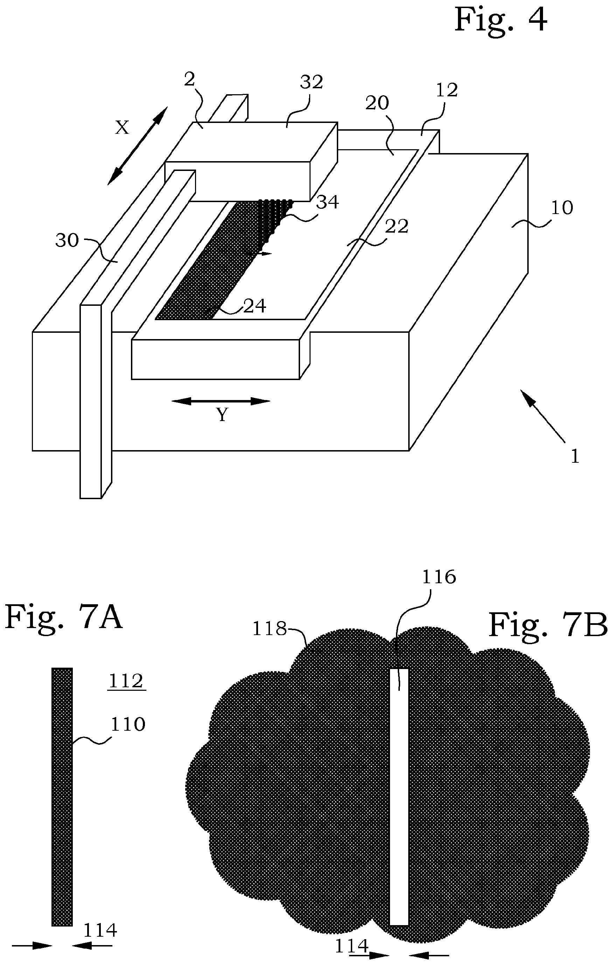

In many pattern printers, simultaneous multiple beams are used. By the use of a printing head having multiple beams for simultaneous exposure, the overall speed can be increased. Figure 4 illustrates schematically a printing device 1, where the printing head 32 is arranged for providing multiple exposure beams 34. The exposure beams 34 are typically microswept, as illustrated by the double arrow, synchronously with each other.

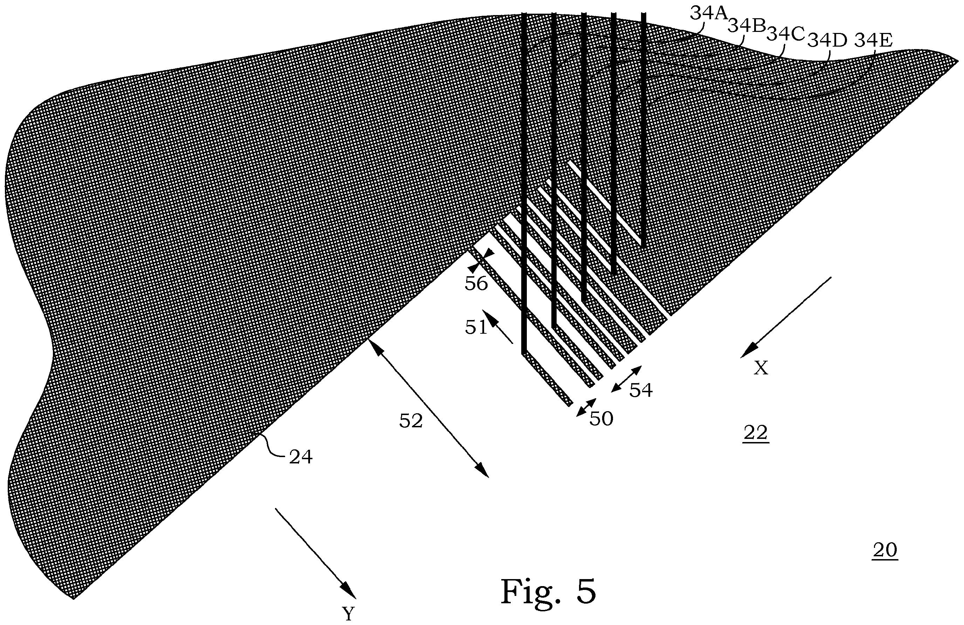

Figure 5 illustrates this in a schematic manner. A portion of the workpiece 20 is shown. In the illustrated moment, an exposed area 24 is illustrated by hatching and an unexposed area 22 is illustrated without.

In the figure, five exposure beams 34A-E are illustrated. As anyone skilled in the art understands, the number of exposure beams can be selected depending on e.g. requested printing speed, available exposure beam sizes, overall complexity etc. However, in this exemplifying illustration, five exposure beams 34A-E have been selected just in order to make the illustration of the printing principles easy to recognize.

In this illustration, the printing head (not shown) is movable stepwise in the X direction downwards in the illustration. The printing head moves with regular distances, illustrated as the exposure beam steps 50. At each position, the exposure beams are swept with a so-called microsweep along the Y direction upwards in the figure, to cover a sweep width 52. In the illustrated instance, the microsweep is almost performed half the way through the microsweep. After the microsweep is finished, the printing head is moved another exposure beam step 50 in the X direction and a new microsweep is made. As can be seen in the figure, when all exposure beams have passed a certain X position, the entire surface of the workpiece is (or could have been) exposed. The different exposure beams are thus planned to fill in the space between each other to build up an exposure of the entire surface. The exposure beam width 56 corresponds to the width of the microstripe that is exposed during a micosweep, and to cover the entire surface, the exposure beam width 56 times the number of exposure beams equals the exposure beam step 50. It can, however, be seen that the exposure beam separation 54 is different from the exposure beam step 50.

In other embodiments, the printing head is moved continuously. The microsweeps are then activated when the printing head comes into the correct position for a microsweep start. The continuous movement results in that the relative position between the stage and printing head changes during the microsweep. This can typically be compensated for in different ways, e.g. performing the microsweep in a small angle relative to the normal of the movement direction, normally denoted as the azimuth angle, to produce a final perpendicular sweep relative the stage. Such arrangements, e.g. implemented by angled sweep optics, are, as such, well-known in prior art.

The motion of the printing head is planned in order for the different exposure beams to cover the entire surface of the workpiece 20.

It was found that the above identified CD linearity properties were essentially independent of if a single exposure beam was used or if a multiple of exposure beams were used for printing the lines.

CD linearity is expected to be influenced by many different measures. This may e.g. comprise improving the laser spot, the laser and optical alignment, minimizing stray light, using best available resist and lithography process. However, since most of these factors have been improved during the years, further improvements would require extreme measures regarding e.g. alignments etc., which is costly and often requires frequent re-calibration procedures.

In this disclosure it is therefore presented, as an alternative to, or a further improvement of, such CD linearity improvement measures, a modification of pattern data in the pixel domain may be used to improve the linearity in the X direction. Thereby more narrow lines can be resolved with linearity inside specification. This has a high value for the users.

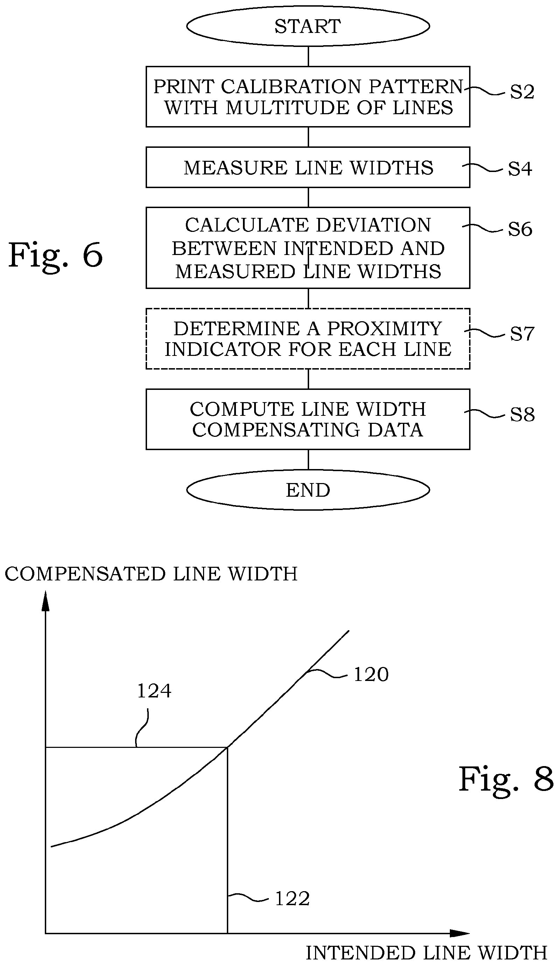

Figure 6 is a flow diagram of steps of an embodiment of a method for obtaining a compensation pattern for a workpiece patterning device. In step S2, a calibration pattern is printed with an exposure beam that is sweepable in a sweep direction. The printing is performed according to calibration pattern print data. The calibration pattern has a multitude of exposed and unexposed lines extending in the sweep direction and having different line widths and different distances to neighboring lines. The line widths are preferably ranging from the smallest possible linewidth that is obtainable by the printer to be used up to line widths that are wide enough for the edges to be considered as non-dependent on each other. For instance, in the system used for obtaining the curve of Figure 3, it could be of interest to compensate line widths between 200 nm and 600 nm, and the line widths of the calibration pattern should in such a case at least cover this range.

In step S4, line widths of the lines are measured in a scan direction perpendicular to the sweep direction in the printed calibration pattern. In step S6, deviations of the measured line widths of the lines relative intended line widths of the edges according to the calibration pattern print data are calculated. In step S8, based on the calculated deviations, line width compensating data is computed. The line width compensating data is intended for adapting line widths of pattern print data prior to printing to compensate for the calculated deviations. The line width compensating data is associated with at least an intended line width and whether the line is an exposed or unexposed line.

Figures 7A-B illustrate the different options. Figure 7A illustrates an exposed line 110. The exposed line 110 is surrounded in the X direction by unexposed areas 112, and is associated with a certain width 114. Figure 7B illustrates analogously an unexposed line 116. The unexposed line 116 is surrounded in the X direction by exposed areas 118, and is also associated with a certain width 114.

Different types of photoresist exist. If a photoresist is used that will remain after etching if being irradiated, an exposed area will result in a "dark field". An unexposed area will then result in a "clear field". This is the type of photo resist that is used as an exemplifying choice in the present disclosure if not explicitly stated differently. However, if a photoresist is used that will be etched away if being irradiated, an exposed area will result in a "clear field". An unexposed area will then instead result in a "dark field". The present ideas are applicable to both alternatives.

For each measure line width, at least two different CD linearity curves are obtained, one for exposed lines and one for unexposed lines.

If a line with a certain intended line width turns out to always be printed with another line width, such inlinearities can be compensated for. If the printed line width is measured to be smaller than the intended one, the original print data can be pre-compensated by requesting a somewhat broader line width. Similarly, if the printed line width is measured to be larger than the intended one, the original print data can be pre-compensated by requesting a somewhat narrower line width. In such case, the finally printed line may assume the originally intended line width. Compensation data can be determined. Figure 8 illustrates an inlinearity compensation curve 120 for an exposed line. This curve behaves in an inverse manner compared to the measured CD linearity. An intended line width 122 is by this curve associated with a compensated line width 124. The curve 120 is thus an example of line width compensating data. The line width compensating data could also be provided in other ways, e.g. as a look-up table, where an intended line width is used as an entrance value.

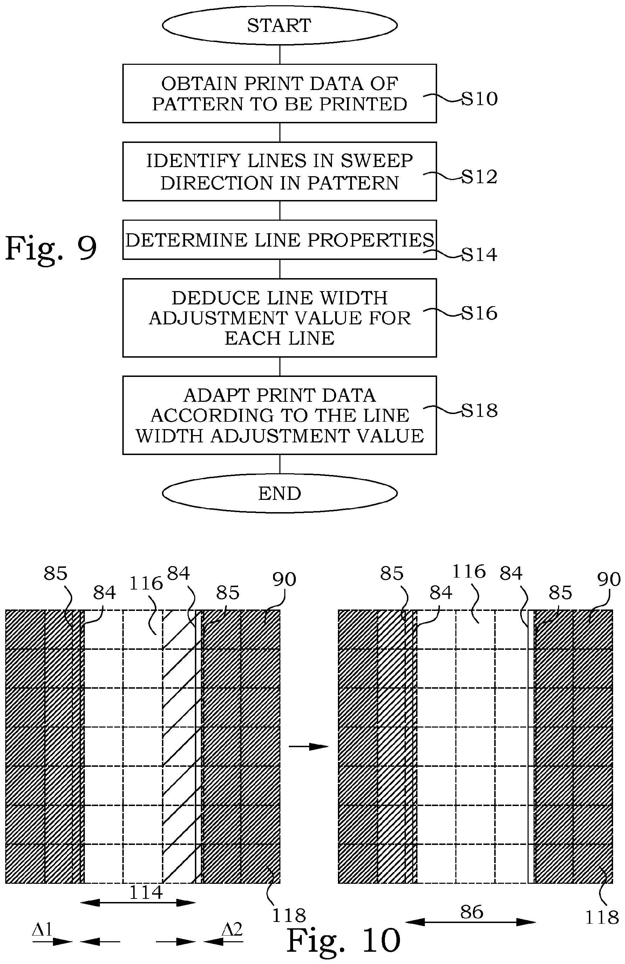

Figure 9 is flow diagram of steps of an embodiment of a method for calibrating print data. In step S10, print data of the pattern to be printed is obtained. In step S12, lines in a sweep direction in the pattern to be printed are identified. In step S14, line properties of the lines are determined. The line properties comprise at least a line width and whether the lines are unexposed or exposed lines. In step S16, a line width adjustment value is deduced for each identified line from line width compensating data obtained by a method according to the description here above. The deduction is based on the determined line width and on whether the line is an unexposed or exposed line. In step S18, the print data defining the identified lines is adapted according to the line width adjustment value. This adaption results in line width compensated print data.

When printing a pattern, the print data is often provided in a vector domain. This is typically converted into a bit map domain, where a raster of pixels are defined associated with individual intensities. When the exposure is performed, the exposure beams are moved according to the pixels and an intensity of the exposure at each pixel is controlled to correspond to the associated intensity values.

The adapting of the print data may be performed in the bit map domain. Figure 10 illustrates schematically a part of a bit map print data, where different pixels 90 are defined by dotted lines. The original bit map print data is illustrated in the left part of the figure. An unexposed line 116 with an intended line width 114 is surrounded by exposed areas 118. The intended edges 84 of the unexposed line 116 do not exactly agree with the pixel borders, and to achieve an exposure that is shifted somewhat from the pixel borders, the associated intensities in the pixels surrounding the unexposed line edge 84 are adjusted to cause a displacement of the position where the exposure reaches the level where the position is to be considered as exposed. The third pixel column from the right is given a low intensity, since the intended edge 84 is situated just inside the right pixel border. Such a use of intensity variations in order to displace pattern edges from pixel borders be distances that are smaller than a width of a pixel, is, as such, well-known by anyone skilled in the art, and will not be further discussed or explained.

According to the line width adjustment ideas presented further above, adjusted line widths may be useful. In the illustrated embodiment, such an adjusted line width is defined by adjusted line edges 85. The edges of the line are thereby requested to be adjusted by amounts Δ1 and Δ2, respectively. The sum of Δ1 and Δ2 corresponds to the amount of the deduced line width adjustment value. In other words, intensities of individual bits at, or immediately adjacent to, each edge of a line to be adjusted are adjusted to achieve a sum of the respective line edge position adjustments that equals the amount of the deduced line width adjustment value.

Adjusted line width compensated print data is illustrated in the right part of Figure 10. Here, the associated intensities are adapted to correspond to the adjusted line edges 85, which gives an adjusted line width 86.

The edge adjustments add up to total deduced line width adjustment value. Preferably, half of the deduced line width adjustment value is adjusted at each edge. However, in other embodiments, another division can be applied. The division may also be dependent on e.g. an unbalance in exposure densities in a respective edge neighbourhood.

When measuring the inlinearities of the line widths, a number of discrete values of line widths are used. From measurements of these discrete values of line widths, line width compensation data is concluded. This may e.g. be assigned line widths compensation values for a set of discrete line widths values or a continuous line width compensation curve. A set of discrete line widths compensation values may be an advantage if e.g. a look-up table is to be used.

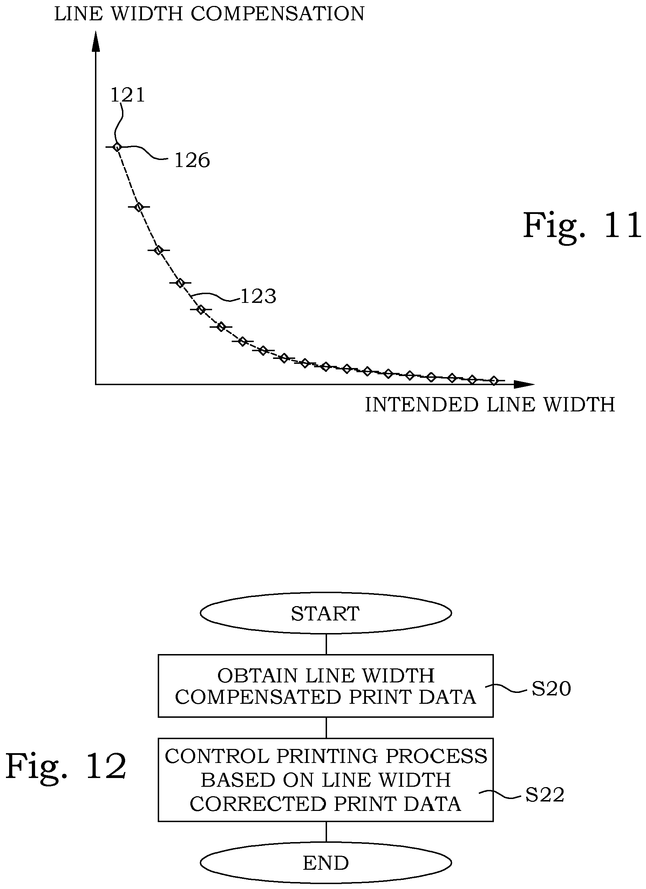

Figure 11 shows a diagram where a set of discrete line width compensation values 121 are determined. These values are valid for an exposed line or an unexposed line, and may, as will be described further below, also be valid for a certain proximity indicator. For intended line widths corresponding exactly to these discrete line width compensation values 121, the selection is obvious. If the intended line width falls between the discrete values, different approaches can be used. One alternative is to determine a closest line width for which a determined discrete line width compensation value 121 exists and use that value. This is illustrated by the short broken lines 126.

Another alternative is to use interpolation. Thus, in one embodiment, the deducing of a line width adjustment value comprises interpolation using line width adjustment values from the line width compensating data corresponding to a closest larger line width and a closest smaller line width. This is illustrated by the dotted lines 123. The interpolation may be linear or according to any other interpolation technique familiar to a person skilled in the art.

When line width compensated print data is available, a printing process may start. Figure 12 is a flow diagram of steps of an embodiment of a method for printing a pattern. In step S20, line width compensated print data of the pattern to be printed is obtained. This line width compensated print data is obtained according the methods described in this disclosure. In step S22, a printing process of a workpiece covered at least partly with a layer sensitive to electromagnetic or electron radiation is controlled based on the line width corrected print data.

As indicated above, use of multiple exposure beams is common. Thus, in one embodiment, the step of controlling S22 the printing process comprises controlling simultaneously operating exposure beams to provide microsweeps in a sweep direction while being scanned in a scan direction, perpendicular to said sweep direction. Thereby scan strips are created.

In a further embodiment, the step of controlling S22 the printing process further comprises creating multiple such scan strips displaced in the second direction.

The printing process may be a micro-lithographic printing process. In different embodiments, the printing process maybe a mask writing process or a direct writing process.

One factor causing the inlinearities in line widths is the influence of radiation exposure intended for adjacent or at least closely positioned pixels. Such "unintended" radiation contributes to a background radiation level, influencing the positions of the edges of the printed lines. This is one important reason why the line compensation is different for exposed lines compared to unexposed lines. However, also the general background radiation level may advantageously be considered. In a preferred embodiment, additional use of a proximity factor is applied.

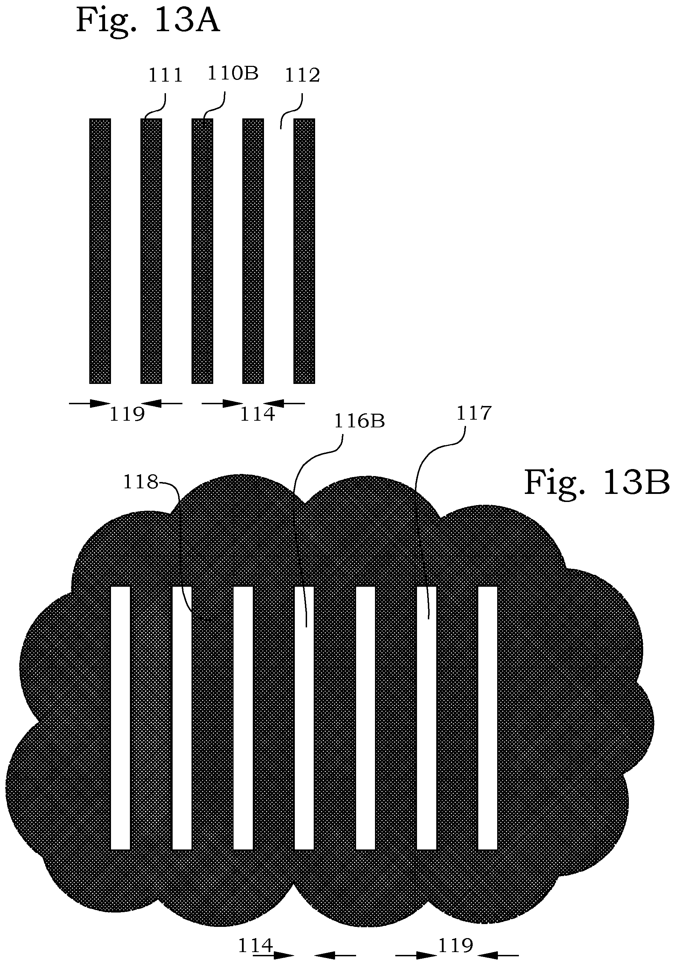

In Figure 7A, an exposed line 110 is illustrated. Since this exposed line 110 is surrounded by a large unexposed area 112, the exposed line 110 may be considered as an isolated exposed line 110. In Figure 13A, an exposed line 110B is illustrated, having a line width 114, but where the surrounding unexposed area 112 is limited. Other exposed areas 111 are therefore present within not too far distances 119 from the exposed line 110B. Such an exposed line 110B may be considered as a dense exposed line. The background radiation level from the neighbouring exposed areas 111 may influence the actual printed line width of the exposed line 110B.

Figure 13B analogously illustrates dense unexposed lines 116B, with a line width 114, having other unexposed areas 117 within a relatively close distance 119. Figure 7B at the contrary illustrates an isolated unexposed line 116.

In one embodiment, a proximity indicator is used for determining the adjustments of the line widths. As indicated in Figure 6, the method for obtaining a compensation pattern for a workpiece patterning device may comprise an additional step S7. In step S7, a proximity indicator is determined for each of the lines in the calibration pattern. The proximity indicator is a parameter representing a relation between exposed or unexposed areas in a surrounding of the lines in the calibration pattern. The line width compensating data is thereby further associated with the proximity indicator.

In the method for calibrating print data, the proximity indicator can be used for further refining the line width adjustments. Thus, in one embodiment, the line properties further comprise a proximity indicator. The proximity indicator is a parameter representing an average fraction of exposed or unexposed areas in a surrounding of the lines. The line width compensating data is further associated with the proximity indicator.

In one embodiment, the proximity indicator is a line density classification having at least two classes. These classes could e.g. be dense lines and isolated lines. A separate line width compensation is then achieved for dense exposed lines, isolated exposed lines, dense unexposed lines and isolated unexposed lines.

In one embodiment, the proximity indicator is a line density measure. Such a line density measure may be a ratio between the distance 119 to a closest neighbor line and a line width 114. This ratio can be evaluated on both sides or on one side, and may then be applied separately on each side or as an average on both sides.

Such line density measure may in some embodiments then be divided into two or more ranges, for classification purposes when deducing a line width adjustment value. In other embodiments, the deducing of a line width adjustment value may comprise interpolation using width adjustment values from the line width compensating data corresponding to a closest larger line density measure and a closest smaller line density measure.

In one embodiment, a range of "fully isolated lines" could be considered to be present if the ratio is larger or equal to 5. The range >2 but <5 could be denoted as "slightly dense", the range >1 but ≤2 could be denoted as "medium dense", and the range ≤1 could be denoted as "very dense".

This proximity indicator as a ratio of distance over line width is an approximation. It assumes that line width influence always comes from only the closest neighbor on each side. However, this is a useful and typical approximation. The most typical cases are the ones where over certain areas, line widths and distances to neighbors remain constant for quite many repetitions in the evaluated direction.

One can say that the proximity indicator as above correspond to a parameter representing an average fraction of exposed or unexposed areas in the surrounding. Dense ratio is one common way to express this, however, it should also be understood that this average is only considered perpendicularly.

The proximity indicator defined in the above manner fits well with typical ways to measure and evaluate CD linearity. Two two-dimensional look-up tables are added. For each line that is measured, the linewidth in the data representation and the distance to closest neighbors in the data representation gives a dense ratio, typically as a decimal value.

In one embodiment, exposed line selects a first look up table and unexposed line selects another look up table. For a discreet number of line widths, there exists a discreet number of correction values for measured dense ratios. In both of these dimensions, linear interpolation, i.e. bi polar linear interpolation, is applied. In other words, linear interpolation is made between the closest line widths and linear interpolation is also made between the closest values of dense ratio.

As mentioned above, the dense ratio may be evaluated single sided or double sided. The compensation may also be the same on both sides, i.e. applied as half on each side, or on each side as the value calculated to best compensate for that sides neighbor light influence.

In one implementation of the above disclosed ideas, a new table-based linewidth compensation for the most narrow linewidths in X direction was adopted. The implementation was based on one-dimensional edge detection in pattern data without light proximity effects, with a sliding window of pixel data, suggested to be approximately 7 to 10 microsweeps of data.

This can be done before or after other types of compensations, e.g. CD compensations or corner enhancements. Furthermore, similar basic technology is used. Even though the necessary alterations are distinctive, they are readily implemented only requiring easily performed adaptions, which limits the implementation costs.

By using a sliding window of size 7, narrow lines up to five pixels can be compensated, i.e. the sliding window size minus two. Each edge can be compensated plus or minus one pixel. For a system where the pixel size is 170 nm, this means that lines narrower in X than 850 nm can be compensated, down to single pixel lines, which typically is much below practical resolution. One example of a sliding window routine is illustrated in Appendix A

As mentioned above, compensation can be done on both clear field lines (exposed on non-exposed background) or dark field lines (non-exposed lines on an exposed background) for photoresists being etchable when irradiated. This compensation table can be created using a combination of linearity model data based on simulations and linearity measurements.

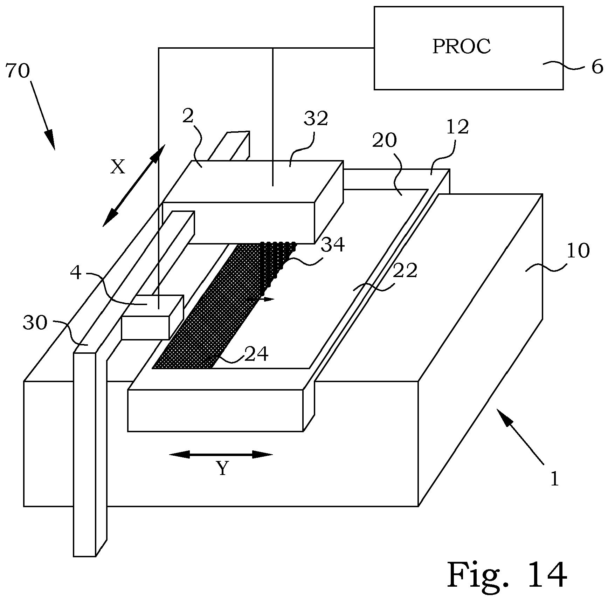

Figure 14 illustrates schematically an embodiment of a system 70 for obtaining a compensation pattern for a workpiece patterning device. The system 70 for obtaining a compensation pattern for a workpiece patterning device comprises a printing device 1 configured for creating a calibration pattern with an exposure beam that is sweepable in a sweep direction. Examples of such a printing device 1 are also shown in Figures 1 and 4. The printing device 1 is configured to perform a printing according to calibration pattern print data. This calibration pattern has a multitude of exposed and unexposed lines extending in the sweep direction having different line widths and different distances to neighboring lines.

The system 70 for obtaining a compensation pattern for a workpiece patterning device further comprises a measuring device 4 arranged for measuring line widths of the lines in a scan direction perpendicular to the sweep direction in the printed calibration pattern. In the illustration, the measuring device 4 is illustrated as a separate unit arranged on a stand 30 of the printing device 1. However, the measuring device 4 may also be provided as a totally separate unit, or as an integrated part of the printing head 32. Measuring devices 4, as such, are well known in prior art and are available in many different configurations. However, as long as the measuring device provides line widths of the lines in a scan direction or data from which such edge positions can be deduced, the details of the measuring device 4 are non-essential, and will therefore not be further described.

The system 70 for obtaining a compensation pattern for a workpiece patterning device further comprises a processing device 6. The processing device 6 is connected to the printing device 1 as well as the measuring device 4. The processing device 6 is configured for calculating deviations of the measured line widths of the lines relative intended line widths of the edges according to the calibration pattern print data.

The processing device 6 is further configured for computing, based on the calculated deviations, line width compensating data for adapting line widths of pattern print data prior to printing to compensate for the calculated deviations. The line width compensating data is associated with at least an intended line width and whether the line is a exposed or unexposed line.

In one embodiment, the processing device is further configured for determining a proximity indicator for each of the lines in the calibration pattern. The proximity indicator is a parameter representing an average fraction of exposed or unexposed areas in a surrounding of the lines in the calibration pattern. The line width compensating data is further associated with the proximity indicator.

In one embodiment, the proximity indicator is a line density classification having at least two classes.

In another embodiment, the proximity indicator is a line density measure.

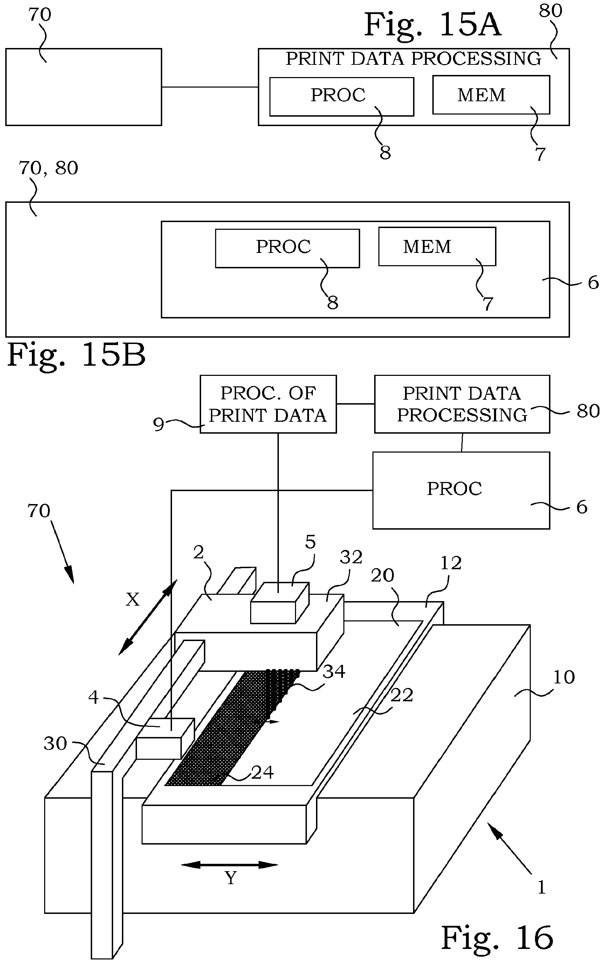

Figure 15A illustrates schematically an embodiment of a device 80 for processing print data defining a pattern to be printed. The device 80 for processing print data defining a pattern to be printed comprise a processing circuitry 8 and a memory 7. The memory 7 comprises instructions executable by the processing circuitry 8, whereby the processing circuitry 8 is operative to obtain print data for the pattern to be printed and to identify lines in a sweep direction in the pattern to be printed. The instruction, when executed by the processing circuitry 8 makes the processing circuitry 8 operative to further determine line properties of the lines and to deduce a line width adjustment value for each identified line from line width compensating data. The line properties comprise at least a line width and whether the lines are unexposed or exposed lines. The line width compensating data is obtained by a method according to the description above and is based on the determined line width and on whether the line is a unexposed or exposed line. The instruction, when executed by the processing circuitry 8 makes the processing circuitry 8 operative to further adapt the print data defining the identified lines according to the line width adjustment value into line width compensated print data. The line width compensating data is obtained by a system 70 for obtaining a compensation pattern, e.g. according to the embodiment of Figure 14.

In one embodiment, the processing circuitry 8 is operative to adapt the print data in a bit map domain. Intensities of individual bits at, or immediately adjacent to, each edge of a line to be adjusted are adjusted to achieve a sum of the respective line edge position adjustments that equals the amount of said deduced line width adjustment value.

In one embodiment, the processing circuitry 8 is operative to deduce a line width adjustment value by interpolation using line width adjustment values from the line width compensating data corresponding to a closest larger line width and a closest smaller line width.

In one embodiment, the line properties further comprise a proximity indicator. The proximity indicator is a parameter representing an average fraction of exposed or unexposed areas in a surrounding of the lines. The line width compensating data is further associated with the proximity indicator.

In a further embodiment, the proximity indicator is a line density classification having at least two classes.

In another further embodiment, the proximity indicator is a line density measure, wherein the processing circuitry is operative to deduce a line width adjustment value by interpolation using width adjustment values from the line width compensating data corresponding to a closest larger line density measure and a closest smaller line density measure.

In Figure 15A, the device 80 for processing print data defining a pattern to be printed is illustrated as a separate unit, in communication with the system 70 for obtaining a compensation pattern. However, as illustrated schematically in Figure 15B, the device 80 for processing print data defining a pattern to be printed may also be provided as a part of and/or integrated in the system 70 for obtaining a compensation pattern. Preferably, the processing circuitry 8 constitutes a part of the processing device 6.

Figure 16 illustrates schematically an embodiment of a printing device 1. The printing device 1 comprises a device 9 for processing of line width compensated print data obtained by a device 80 for processing print data according to the ideas presented here above. The printing device 1 is the printing device of the system 70 for obtaining a compensation pattern for a workpiece patterning device. The printing device 1 comprises a printing head 32 having at least one exposure beam being sweepable in a sweep direction. The printing device 1 further comprises a control unit 5. The control unit 5 is arranged to control an operation and relative motion of the printing head based on the line width compensated print data.

In Figure 14, the control unit 5 and the device 9 for processing of edge compensated print data are illustrated as separate units. However, they may also be integrated into a common unit. Also, the processing circuitry of the device 80 for processing print data may be integrated in the same unit as the control unit 5 and/or the device 9 for processing of edge compensated print data. Also, the processing device 6 can be a part of a common unit.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

### Appendix - A sliding window routine

```
 Sliding window stream buffer with 7 microsweeps ST data (five left + center + right)
 Scanning scanstrip-by-scanstrip ST data from right to left (Prexision/SLX).
 L5 L4 L3 L2 L1 C R1 : current microsweeps (left five pixels, center, right pixel)
 UL5 UL4 UL3 UL2 UL1 UC UR1 : unmodified microsweep copies (to remember edge compensations)
 for (X from rightmost microsweep of scanstrip to leftmost microsweep of scanstrip)
 {
    for (Y for all microsweep stubs fragmented to constant intensity (L5,L4,L3,L2,L1,C,R1)
          within microsweep sliding window)
    {
          // First, Detect clear field line right edge by state of pixels R1,C,L1
          if Rl == white && (C == gray or black) && L1 == black => Right edge of CF line
          // (This is by definition also the left edge of a DF line)
          // if this edge was previously compensated as a DF line, then no CF compensation is
                made
          if (right edge CF) {
                if (C==gray && C<>UC) then this right edge already compensated as DF line
                if (C==black && C<>UC) then this right edge already compensated as DF line
                if not (already compensated as DF line) {
                       Linewidth (in pixels) LW=1.0 + grayness of C
                             while (i in stream buffer left) until
 non-black pixel { LW+=grayness of
                                   pixel[i] }
                             if (matching left edge found) {
                                   dx = SOLIX Table [LW, polarity=pos, Beamnr of C, XHR of C]
                                   Right Edge[C] XHR+= dx (outwards or inwards)
                                   Left Edge[i] XHR+= dx (outwards or inwards)
                             } // else: this CF line is wider
 than 5 pixels and need no compensation } }
          // Second, Detect dark field line right edge by state of pixels R1,C,L1
          if Rl == black && (C == gray or white) && L1 == white => Right edge of DF line
          // (This is by definition also the left edge of a CF line)
          // if this edge was previously compensated as a CF line, then no DF compensation is
                made
          if (right edge DF) {
                if (C==gray && C<>UC) then this right edge already compensated as CF line
                if (C==white && C<>UC) then this right edge already compensated as CF line
                if not (already compensated as CF line) {
                       Linewidth (in pixels) LW=1.0 + (1-grayness of C)
                       while (i in stream buffer left) until
non-white pixel { LW+=(1-grayness of
                             pixel[i]) }
                       if (matching left edge found) {
                             dx = SOLIX Table [LW, polarity=neg, Beamnr of C, XHR of C]
                             Right Edge[C] XHR+= dx (outwards or inwards)
                             Left Edge[i] XHR+= dx (outwards or inwards)
                       } // else: this DF line is wider than
5 pixels and need no compensation } } }
    Slide microsweep window one step and repeat until end of scanstrip:
    Rl : push to output ST file
    Rl = C, C = L1, ... L4 = L5
    L5 = get next microsweep from ST input file
    + slide the unmodified microsweep buffers same way }
```

## Claims

1. A method for obtaining a compensation pattern for a workpiece patterning device, comprising the steps of:
- printing (S2) a calibration pattern with an exposure beam (32) being sweepable in a sweep direction (Y);
said printing (S2) being performed according to calibration pattern print data;
said calibration pattern having a multitude of exposed and unexposed lines extending in said sweep direction (Y) having different line widths and different distances to neighboring lines;
- measuring (S4) line widths of said lines in a scan direction (X) perpendicular to said sweep direction (Y) in said printed calibration pattern;
- calculating (S6) deviations of said measured line widths of said lines relative intended line widths of said edges according to said calibration pattern print data;
- computing (S8), based on said calculated deviations, line width compensating data (123, 126) for adapting line widths of pattern print data prior to printing to compensate for said calculated deviations;
said line width compensating data (123, 126) being associated with at least an intended line width and whether said line is an exposed or unexposed line.

2. The method according to claim 1, **characterized by** the further step of:
- determining (S7) a proximity indicator for each of said lines in said calibration pattern;
said proximity indicator being a parameter representing a ratio between a distance (119) to a closest neighbor line and a line width (114); and
wherein said line width compensating data being further associated with said proximity indicator.

3. A method for calibrating print data, comprising the steps of:
- obtaining (S10) print data of said pattern to be printed;
- identifying (S12) lines in a sweep direction (Y) in said pattern to be printed;
- determining (S14) line properties of said lines, said line properties comprising at least a line width and whether the lines are unexposed (110; 110B) or exposed (116; 116B) lines;
- deducing (S16) a line width adjustment value for each identified line from line width compensating data (123, 126) obtained by a method according to claim 1 based on said determined line width and on whether the line is an unexposed (110, 110B) or exposed line (116; 116B); and
- adapting (S18) said print data defining said identified lines according to said line width adjustment value into line width compensated print data.

4. The method according to claim 3, **characterized in that**
said adapting (S18) of said print data is performed in a bit map domain;
wherein intensities of individual bits (90) at, or immediately adjacent to, each edge (84) of a line to be adjusted are adjusted to achieve a sum of the respective line edge position adjustments that equals the amount of said deduced line width adjustment value.

5. The method according to claim 3 or 4, **characterized in that**
said deducing (S16) of a line width adjustment value comprises interpolation using line width adjustment values from said line width compensating data corresponding to a closest larger line width and a closest smaller line width.

6. The method according to any of the claims 35 to 5, **characterized in that**
said line properties further comprises a proximity indicator;
said proximity indicator being a parameter representing a ratio between a distance (119) to a closest neighbor line and a line width (114); and
wherein said line width compensating data being further associated with said proximity indicator.

7. A method for printing a pattern, comprising the steps of:
- obtaining (S20) line width compensated print data obtained by a method according to claim 3 of said pattern to be printed; and
- controlling (S22) a printing process of a workpiece (20) covered at least partly with a layer sensitive to electromagnetic or electron radiation based on said line width corrected print data.

8. The method according to claim 7, **characterized in that** said step of controlling (S22) said printing process comprises controlling simultaneously operating exposure beams (34) to provide microsweeps in a sweep direction (Y) while being scanned in a scan direction (X), perpendicular to said sweep direction (Y), thereby creating scan strips.

9. The method according to claim 8, **characterized in that** said step of controlling (S32) said printing process further comprises creating multiple said scan strips displaced in said sweep direction.

10. A system (70) for obtaining a compensation pattern for a workpiece patterning device, comprising:
- a printing device (1) configured for creating a calibration pattern with an exposure beam (34) being sweepable in a sweep direction (Y);
said printing device (1) being configured to perform said printing according to calibration pattern print data;
said calibration pattern having a multitude of exposed (110; 110B) and unexposed (116; 116B) lines extending in said sweep direction (34) having different line widths and different distances to neighboring lines;
- a measuring device (4) arranged for measuring line widths of said lines in a scan direction (X) perpendicular to said sweep direction (Y) in said printed calibration pattern; and
- a processing device (6) configured for calculating deviations of said measured line widths of said lines relative intended line widths of said edges according to said calibration pattern print data;
said processing device (6) being further configured for computing, based on said calculated deviations, line width compensating data for adapting line widths of pattern print data prior to printing to compensate for said calculated deviations;
said line width compensating data being associated with at least an intended line width and whether said line is an exposed (110; 110B) or unexposed (116; 116B) line.

11. The system according to claim 10, **characterized in that**
said processing device (6) being further configured for determining a proximity indicator for each of said lines in said calibration pattern;
said proximity indicator being a parameter representing an average fraction of exposed (118) or unexposed (112) areas in a surrounding of said lines in said calibration pattern; and
wherein said line width compensating data being further associated with said proximity indicator.

12. A device (80) for processing print data defining a pattern to be printed, comprising:
- processing circuitry (8); and
- a memory (7);
said memory (7) comprising instructions executable by the processing circuitry (8), whereby the processing circuitry (8) is operative to:
obtain print data for said pattern to be printed;
identify lines (110, 110B; 116, 116B) in a sweep direction in said pattern to be printed;
determine line properties of said lines (110, 110B; 116, 116B), said line properties comprising at least a line width and whether the lines are unexposed (116, 116B) or exposed (110, 110B) lines;
deduce a line width adjustment value for each identified line from line width compensating data obtained by a method according to claim 1 based on said determined line width and on whether the line is an unexposed (116,116B) or exposed (110, 110B) line; and to
adapt said print data defining said identified lines according to said line width adjustment value into line width compensated print data.

13. The device according to claim 12, **characterized in that**
said processing circuitry (8) is operative to adapt said print data in a bit map domain, wherein intensities of individual bits (90) at, or immediately adjacent to, each edge (84) of a line to be adjusted are adjusted to achieve a sum of the respective line edge position adjustments that equals the amount of said deduced line width adjustment value.

14. The device according to claim 12 or 13, **characterized in that**
said processing circuitry (8) is operative to deduce a line width adjustment value by interpolation using line width adjustment values from said line width compensating data corresponding to a closest larger line width and a closest smaller line width.

15. A printing device (1), comprising:
- a device for processing (6) of line width compensated print data obtained by a device for processing print data according to claim 12;
whereby said printing device (1) being the printing device (1) of said system (70) for obtaining a compensation pattern for a workpiece patterning device of claim 10;
- a printing head (32) having an exposure beam (34) being sweepable in a sweep direction (Y); and
- a control unit (5);
said control unit (5) being arranged to control an operation and relative motion of said printing head (32) based on said line width compensated print data.
